# EUROPEAN PATENT APPLICATION

(11) **EP 4 372 126 A1**
(43) Date of publication of application: **22.05.2024**
(21) Application number: 22841740.8
(22) Date of filing: 29.03.2022
(51) Int. Cl.: C25B 11/052, C25B 11/063, C25B 11/093, C25B 11/097

(54) **ELECTRODE FOR INDUSTRIAL ELECTROLYTIC PROCESS**

(30) Priority: 12.07.2021 JP 2021114679
(71) Applicant: De Nora Permelec Ltd, Fujisawa-shi, Kanagawa 252-0816 (JP)
(72) Inventor: FURUSAWA, Takashi, Fujisawa-shi, Kanagawa 252-0816 (JP); KATO, Akihiro, Fujisawa-shi, Kanagawa 252-0816 (JP); MIYAKAWA, Eri, Fujisawa-shi, Kanagawa 252-0816 (JP); TIMPANO, Fabio, 20134 Milan (IT); CALDERARA, Alice, 20134 Milan (IT)
(74) Representative: Wächtershäuser & Hartz Patentanwaltspartnerschaft mbB
(86) International application number: PCT/JP2022/015357
(87) International publication number: WO 2023/286392

(57) **Abstract**

The object of the present invention is to provide an electrode having high durability and lower manufacturing costs and a method for manufacturing the same.

An electrode comprising a coating that contains a mixed metal oxide on a valve metal substrate with an intermediate layer therebetween that contains an alloy that contains a titanium component and a tantalum component, wherein the molar ratio of metal elements in the mixed metal oxide is 35 to 48% for the total of an iridium element and a ruthenium element, 45 to 60% of a tin element, and 3 to 9% of a tantalum element, and the molar ratio of the iridium element to the total of the iridium element and the ruthenium element in the mixed metal oxide is 32 to 60% inclusive.

## Description

### TECHNICAL FIELD

The present invention relates to an electrode for oxygen generation in an industrial electrolysis process such as electrowinning and electroplating and a method for manufacturing the same.

### BACKGROUND

Electrodes coated with a mixed metal oxide containing a platinum group metal oxide and having a corrosion resistant metal typified by titanium as a substrate are known as excellent insoluble electrodes, and have been widely and industrially put to practical use in various electrochemical fields, especially as electrodes for oxygen generation. Concerning these types of electrodes, while there have been a variety of improvements to their electrochemical characteristics as well as improvements to their physical characteristics such as durability and the like, even now, such improvements cannot be considered sufficient. In particular, when electrolyzing in a solution containing sulfuric acid or a salt thereof in an electrolytic solution, electrodes mainly employed for an oxygen generation reaction are placed in extremely harsh environments and the life span thereof is shortened. Furthermore, the progress of the electrochemical industry in recent years has strongly demanded improvement of product characteristics and productivity, and the electrolytic conditions such as diversification of electrolytic solutions, and increase of current density and electrolytic temperature have become more severe, and a further improvement in the durability of used electrodes is also desired.

Therefore, as a composition suitable for exerting a catalytic action on the oxygen generation reaction, for example, an electrode using a composition comprising a mixture of oxides of iridium and tin has been proposed (Patent Document 1). Such an electrode excels in terms of durability, but since it contains a large amount of iridium oxide, the manufacturing costs increase due to the skyrocketing price of iridium, which is the material.

As a candidate for an alternative substance to iridium oxides, an oxide of the same platinum group metal as iridium was considered. However, ruthenium oxides (RuO₂) are known to be less stable than iridium at high current densities (Non-Patent Document 1), and these were considered unsuitable as an alternative substance for iridium oxides in high current density applications.
[Patent Document 1] JP H2-247393 A
[Non-Patent Document 1] Characterization of DSA-type O2 evolving electrodes, Journal of Applied Electrochemistry, 1991, 21, p. 335-345

### SUMMARY OF INVENTION

The present invention aims to provide an electrode having high durability at lower manufacturing costs as well as a method for manufacturing the same.

As a result of various studies and research, the present inventors have obtained the finding that the manufacturing costs can be suppressed while maintaining high durability by replacing a part of the iridium oxide with ruthenium oxide, thus leading to the completion of the present invention.

That is, the present invention is related to the following:
[1] An electrode comprising a coating that contains a mixed metal oxide on a valve metal substrate with an intermediate layer therebetween that contains an alloy that contains a titanium component and a tantalum component, wherein the molar ratio of metal elements in the mixed metal oxide is 35 to 48% for the total of an iridium element and a ruthenium element, 45 to 60% of a tin element, and 3 to 9% of a tantalum element, and the molar ratio of the iridium element to the total of the iridium element and the ruthenium element in the mixed metal oxide is 32 to 60% inclusive.
[2] The electrode according to [1], wherein the molar ratio of the metal elements in the mixed metal oxide is 12 to 25% of the iridium element, 18 to 29% of the ruthenium element, 45 to 60% of the tin element, and 3 to 9% of the tantalum element, and the molar ratio of the iridium element to the total of the iridium element and the ruthenium element in the mixed metal oxide is 33 to 52% inclusive.
[3] The electrode according to [1] or [2], wherein the molar ratio of the metal elements in the mixed metal oxide is 13 to 16% of the iridium element, 24 to 28% of the ruthenium element, 50 to 56% of the tin element, and 4 to 8% of the tantalum element, and the molar ratio of the iridium element to the total of the iridium element and the ruthenium element in the mixed metal oxide is 34 to 40% inclusive.
[4] The electrode according to any one of [1]-[3], wherein the electrode is for oxygen generation in an electrolysis process.
[5] A method for manufacturing an electrode, the method comprising 1) a step for forming, on a surface of a valve metal substrate, an intermediate layer precursor that contains an alloy that contains a titanium component and a tantalum component by means of an arc ion plating method, 2) a step for forming a coating precursor by applying, to the surface of the intermediate layer precursor, a solution containing iridium ions, ruthenium ions, tin ions, and tantalum ions and drying said solution, and 3) a step for heat processing in an atmosphere containing oxygen for 30 minutes to two hours at a temperature of 400 to 600°C.

The present invention can provide an electrode having high durability at lower manufacturing costs.

### DESCRIPTION OF EMBODIMENTS

Below, one embodiment of the present invention is explained in detail. The present invention is not limited to the following embodiment, and it is possible to appropriately add changes and carry out the invention insofar as the effects of the present invention are not hindered. In the following explanation, "A to B" means "equal to or greater than A and equal to or less than B."

The electrode according to a first embodiment of the present invention comprises a coating that contains a mixed metal oxide on a valve metal substrate with an intermediate layer therebetween containing an alloy that contains a titanium component and a tantalum component, wherein the molar ratio of metal elements in the mixed metal oxide is 35 to 48% in the total of an iridium element and a ruthenium element, 45 to 60% of a tin element, and 3 to 9% of a tantalum element, and the molar ratio of the iridium element to the total of the iridium element and the ruthenium element in the mixed metal oxide is 32 to 60% inclusive. With such a configuration, it is possible to provide high durability and more reduced manufacturing costs. In addition, this is an electrode suitable for oxygen generation in an electrolysis process.

### <Valve Metal Substrate>

In the present embodiment, the valve metal substrate is not particularly limited to its material or shape if it has conductivity and appropriate rigidity. It is possible to use titanium, tantalum, niobium, zirconium, hafnium, vanadium, molybdenum, and tungsten as the valve metal. Further, it is also possible to use a good conductive metal such as Cu or Al if the surface is made sufficiently corrosion-resistant by a corrosion-resistant coating containing an amorphous layer. In the present embodiment, titanium or a titanium-based alloy is suitably used as the material of the valve metal substrate. Titanium and titanium-based alloys are preferable because of their corrosion resistance and their economical properties, as well as their high strength/specific gravity, that is, their specific strength, and because they are relatively easy to process such as by rolling and processing techniques such as cutting have been greatly improved in recent years. The shape may be a simple rod shape or plate shape, or a complicated shape such as one formed by machining, and the surface can be smooth or porous. Here, the surface means a part that can come into contact with an electrolytic solution when immersed in the electrolytic solution.

In addition, if necessary, physical and chemical pretreatments such as annealing, surface roughening, and surface cleaning are appropriately performed in advance. For cleaning, water cleaning, alkaline cleaning, ultrasonic cleaning, steam cleaning, scrub cleaning and the like can be used. The surface roughening is performed by blasting, and by increasing the surface area, the bonding strength can be increased and the electrolytic current density can be substantially reduced. The surface cleaning is carried out by using a non-oxidizing acid such as hydrochloric acid, sulfuric acid, or oxalic acid or a mixed acid thereof at a boiling point or a temperature close to the boiling point, or by using a nitric hydrofluoric acid at a temperature near room temperature. After that, as a finishing, rinsing with pure water is performed and then allowed to dry sufficiently. Before using the pure water, it is preferable to rinse with a large amount of tap water. The arithmetic average roughness Ra after surface roughening is preferably 0.1 µm or more, more preferably 1.0 µm or more, and even more preferably 1.5 µm or more.

### <Intermediate Layer>

In the present embodiment, an intermediate layer containing an alloy that contains a titanium component and a tantalum component is formed on the valve metal substrate (preferably so as to contact the valve metal substrate). The preferred combination of metals used to form the intermediate layer is a combination of tantalum and titanium, or at least one metal selected from the three metals of niobium, zirconium, and hafnium in addition to tantalum and titanium. Using these metals, the intermediate layer can be formed on the surface of the valve metal substrate and all the metals in the intermediate layer are crystalline.

Further, in one embodiment of the present invention, the ratio of the titanium component and the tantalum component present in the intermediate layer is preferably 95:5 to 5:95 in terms of molar ratio, more preferably 90:10 to 10:90, and even more preferably 80:20 to 20:80.
The measurement of the ratio of metal elements in the intermediate layer can be calculated from the raw materials used for the intermediate layer precursor, but it is also possible to measure this with a fluorescent X-ray device and/or a high frequency inductively coupled plasma (ICP) emission spectral analysis method.

In a further embodiment, the intermediate layer also contains substances other than the titanium component and the tantalum component (for example, at least one metal selected from the three metals of niobium, zirconium, and hafnium). The ratio of these substances contained in the intermediate layer is preferably 50 mol% or less, more preferably 30 mol% or less, and even more preferably 10 mol% or less.

The average thickness of the intermediate layer may be appropriately selected from a practical point of view such as corrosion resistance and productivity, but is preferably 0.1 to 10 µm, more preferably 0.5 to 5 µm, and even more preferably 1 to 3 µm. For the average thickness of the intermediate layer, the thickness of at least five points is measured from a cross-sectional photographic image obtained by using a scanning electron microscope, and the average value is taken as the average thickness.

### <Coating>

In the present embodiment, the coating containing a mixed metal oxide is formed on the intermediate layer (preferably so as to contact the intermediate layer). The molar ratio of metal elements in the mixed metal oxide is 35 to 48% for the total of an iridium element and a ruthenium element, 45 to 60% of a tin element, and 3 to 9% of a tantalum element, and the molar ratio of the iridium element to the total of the iridium element and the ruthenium element in the mixed metal oxide is 32 to 60% inclusive.

More preferably, the molar ratio of the metal elements in the mixed metal oxide is 12 to 25% of the iridium element, 18 to 29% of the ruthenium element, 45 to 60% of the tin element, and 3 to 9% of the tantalum element, and the molar ratio of the iridium element to the total of the iridium element and the ruthenium element in the mixed metal oxide is 33 to 52% inclusive.

Even more preferably, the molar ratio of the metal elements in the mixed metal oxide is 13 to 16% of the iridium element, 24 to 28% of the ruthenium element, 50 to 56% of the tin element, and 4 to 8% of the tantalum element, and the molar ratio of the iridium element to the total of the iridium element and the ruthenium element in the mixed metal oxide is 34 to 40% inclusive.

The measurement of the ratio of the metal elements in the coating can be calculated from the raw materials used for the coating precursor, but can also be measured by using a fluorescent X-ray device and/or a high frequency inductively coupled plasma (ICP) emission spectral analysis method or the like.

The iridium element, the ruthenium element, the tin element, and the tantalum element in the coating are respectively present as oxides. Examples of iridium oxides include IrO₂. Examples of ruthenium oxides include RuO₂. Examples of tin oxides include SnO₂. Examples of tantalum oxides include Ta₂O₅.

The amount of iridium oxide and ruthenium oxide in the coating is preferably 1 g/m² or more in total in terms of the constituent component metals.

In a certain embodiment, the coating comprises only iridium oxide, ruthenium oxide, tin oxide, tantalum oxide, and unavoidable impurities, but in a further embodiment, the coating also contains substances aside from the abovementioned oxides. The substances other than the abovementioned oxides that can be contained in the coating are not particularly limited, and examples thereof include niobium oxides, molybdenum oxides, and tungsten oxides.
The content of oxides aside from iridium oxide, ruthenium oxide, tin oxide, and tantalum oxide is preferably 5 mol% or less, and more preferably 3 mol% or less.

### (Electrode Applications)

In the electrode according to the present embodiment, when an electrolytic solution containing a sulfate is electrolyzed at an electrolysis temperature of 50°C, an electrolysis area of 30 mm × 30 mm, and a current density of 32 A/dm², the increase in cell voltage after 1500 hours is 2.0 V or less. That is, since the electrode according to the present embodiment has high durability, it can be used as an electrode in various applications. In particular, it can preferably be used as an electrode for oxygen generation in an electrolysis process.

### <Method for Manufacturing the Electrode>

The method for manufacturing the electrode according to the present embodiment comprises 1) a step for forming, on a surface of a valve metal substrate, an intermediate layer precursor that contains an alloy that contains a titanium component and a tantalum component by means of an arc ion plating (AIP) method, 2) a step for forming a coating precursor by applying, to the surface of the intermediate layer precursor, a solution containing iridium ions, ruthenium ions, tin ions, and tantalum ions and drying said solution, and 3) a step for heat processing in an atmosphere containing oxygen for 30 minutes to two hours at a temperature of 400 to 600°C.

### (Step 1: Formation of the Intermediate Layer Precursor)

In the present embodiment, the intermediate layer precursor is formed using an AIP method. The AIP method refers to a method that causes an arc discharge using a metal target (evaporation source) as a cathode in a vacuum, and the electric energy generated by the arc discharge instantly evaporates the target metal and at the same time causes it to pop out into the vacuum, and meanwhile, by applying a bias voltage (negative pressure) to the object to be coated, metal ions are accelerated and brought into close contact with the surface of the object to be coated together with the reaction gas particles to form a strong and dense film. With the AIP method, an ultra-hard film can be formed with a strong adhesion by using the astonishing energy of the arc discharge. Further, due to the characteristics of the vacuum arc discharge, the ionization rate of the target material is high, and a dense film having excellent adhesion can be easily formed at high speed.

As a dry coating technique, there are Physical Vapor Deposition (PVD) and Chemical Vapor Deposition (CVD), and while the AIP method is one kind of ion plating method, which is a typical PVD method, it is a special ion plating method that uses a vacuum arc discharge. Accordingly, with this AIP method, a high evaporation rate can be easily obtained, the method makes the evaporation of metals with a high melting point possible, and also makes it possible to evaporate, with an alloy composition ratio substantially as is, alloy target materials that combine materials with different melting points and vapor pressures, which is difficult with other ion plating methods, and this is an essential method for forming the underlying layer according to the present invention.

As described above, the preferred combination of metals used to form the intermediate layer is tantalum and titanium or a combination of at least one metal selected from the three metals of niobium, zirconium, and hafnium in addition to tantalum and titanium.

Further, after the above step 1, heat processing may be performed in an air atmosphere. The temperature of the heat processing is preferably 450 to 650°C, more preferably 500 to 600°C, and even more preferably 520 to 550°C. Further, the heat processing time is preferably 30 minutes to three hours.

### (Step 2: Formation of the Coating Precursor)

For the coating in the present embodiment, a coating precursor is formed by applying a solution containing iridium ions, ruthenium ions, tin ions, and tantalum ions and then dried.

As the raw material of the iridium ions, it is possible to use iridium hydroxyacetochloride complex solutions and iridium (III) chloride, or iridium acid chloride salts. As the raw material of the ruthenium ions, it is possible to use ruthenium hydroxyacetochloride complex solutions or ruthenium (III) chloride salts. As the raw material of the tin ions, it is possible to use hydroxyacetochloride complex solutions or tin (IV) chloride salts. As the raw material of the tantalum ions, it is possible to use tantalum pentachloride salts.

The concentration of the iridium element in the solution is, for example, preferably 5 to 30 g/L and is more preferably 10 to 25 g/L.
The concentration of the ruthenium element in the solution is, for example, preferably 5 to 30 g/L and is more preferably 10 to 25 g/L.
The concentration of the tin element in the solution is, for example, preferably 10 to 70 g/L and is more preferably 20 to 60 g/L.
The concentration of the tantalum element in the solution is, for example, preferably 2 to 15 g/L and is more preferably 4 to 12 g/L.

The molar ratio of iridium ions, ruthenium ions, tin ions, and tantalum ions in the solution is preferably 35 to 48: 45 to 60: 3 to 9 in: total of iridium ions and ruthenium ions: tin ions: tantalum ions.
Further, as the molar ratio of iridium ions: ruthenium ions: tin ions: and tantalum ions, 12 to 25: 18 to 29: 45 to 60: 3 to 9 is more preferable, and is even more preferably 13 to 16: 24 to 28: 50 to 56: 4 to 8.
The molar ratio of the iridium element to the total of the iridium element and the ruthenium element is preferably 32% or more and 60% or less, more preferably 33% or more and 52% or less, and even more preferably 34% or more and 40% or less.

The method of applying the solution is not particularly limited, and conventionally known methods such as spray coating, brush coating, roller coating, spin coating, and electrostatic coating can be used.
As a method for forming a coating precursor, it is also possible to use a film forming technique such as CVD or PVD as another method for applying the solution to the surface.

The temperature for drying the applied solution is preferably 30 to 90°C, more preferably 40 to 80°C, and even more preferably 50 to 70°C. The drying time is preferably 5 to 30 minutes, more preferably 5 to 20 minutes, and even more preferably 5 to 15 minutes.

### (Step 3: Heat Processing)

The coating is formed by heat processing the coating precursor in an atmosphere containing oxygen for 30 minutes to two hours at a temperature of 400 to 600°C. Due to the heat processing, it is possible to obtain desired oxides as the coating components and the coating strength is improved. The heat processing temperature is preferably 400 to 600°C, more preferably 450 to 550°C, even more preferably 475 to 525°C, and particularly preferably 500°C. That is, the manufacturing method for the electrode according to the present embodiment can be carried out under practical temperature conditions that enable mass production and thus has high productivity.
The heat processing time is preferably 5 to 60 minutes, more preferably 5 to 20 minutes, even more preferably 5 to 15 minutes, and particularly preferably 10 minutes.
By repeating the above steps 3 to 30 times, for example, the amount of metal in the coating can be set to a desired value.

After the third step, post-heating processing may be performed. The temperature of the post-heating processing is 400 to 600°C, preferably 450 to 550°C, more preferably 475 to 525°C, and particularly preferably 500°C. In addition, the time of the post-heating processing is preferably 30 minutes to two hours, more preferably 30 minutes to 1.5 hours, and even more preferably one hour.

The atmosphere containing oxygen contains sufficient oxygen to obtain iridium oxides, nickel oxides, and lithium oxides by heat processing. Examples of the oxygen concentration of the atmosphere containing oxygen include 1 to 40%, 5 to 30%, and 10 to 25%.

### <Other Processing>

In order to increase the adhesion of the coating, before the step for applying the solution (step 2), the surface of the intermediate layer formed on the valve metal substrate may be subjected to a surface roughening process. Examples of the surface roughening process include a blasting process, an etching process using a substrate-soluble acid or alkali, a plasma spraying process, and the like. Further, it is preferable to perform a chemical etching process for removing contaminants on the surface. The arithmetic average roughness Ra after the surface roughening process is preferably 0.1 µm or more, more preferably 1.0 µm or more, and even more preferably 1.5 µm or more.

### EXAMPLES

Below, the examples of the present invention are indicated. The subject matter of the present invention should not be interpreted as being limited to these examples.

### (Example 1)

A JISI type titanium plate was prepared as the valve metal substrate, a dry-type blasting process was performed on the surface thereof with iron grit (G120 size), and then acid-washed for ten minutes in a boiling concentrated hydrochloric acid aqueous solution, and then a washing process of the valve metal substrate was performed. The thus washed valve metal substrate was set in an arc ion plating apparatus using a Ti-Ta alloy target as an evaporation source, and the surface of the valve metal substrate was coated with a Ti-Ta alloy to form an intermediate layer. The coating conditions are as shown in Table 1.

**[Table 1]**

| Target (Evaporation Source) | Alloy disk containing Ti:Ta = 40 wt%:60 wt% (back surface cooling) |
|---|---|
| Vacuum Arrival Pressure | 1.5×10⁻² Pa or less |
| Gas Temperature | 500°C or less |
| Coating Pressure | 3.0×10⁻¹ to 4.0×10⁻¹ Pa |
| Evaporation Source Input Power | 20 to 30 V, 140 to 160 A |
| Coating Time | 15 to 20 minutes |
| Coating Thickness | 2 microns (weight increase conversion) |

Next, the valve metal substrate having the intermediate layer formed thereon was heat processed for 180 minutes at 530°C under an air atmosphere.

Next, a 1.65 M tin hydroxyaceto chloride complex solution was prepared in a similar manner as described in WO 2005/014885 A. In addition, a 0.9 M iridium hydroxyaceto chloride complex solution was prepared in a similar manner as described in WO 2010/055065 A. In addition, a 0.9 M ruthenium hydroxyaceto chloride complex solution was prepared in a similar manner as described in WO 2010/055065 A. Further, a 125 g/L tantalum solution was prepared by dissolving tantalum pentachloride in concentrated hydrochloric acid. The above solutions were mixed to prepare an application liquid having a molar ratio of Ir:Ru:Sn:Ta of 21:20:53:6.
The prepared application liquid was applied to the intermediate layer and dried for ten minutes at 60°C, was heat processed for ten minutes at 480°C in an air-circulating type electric furnace, then cooled in open air to form the coating. The amount of the application liquid was set so that the application thickness per one application of the application liquid becomes approximately 0.5 g/m² in terms of iridium metal, and this application-to-baking operation was repeated 12 times to obtain a coating with, in terms of iridium and ruthenium metal, about 12 g/m². After this, post-heat processing (post-baking) was performed for one hour at 520°C in the air-circulating type electric furnace to manufacture the electrode.

### (Example 2 and Comparative Examples 1-4)

Similar to Example 1, the electrodes of Example 2 and Comparative Examples 1-4 were prepared using the respective materials so that the coating has the composition shown in Table 2.

### (Comparative Example 5)

The electrode of Comparative Example 5 was manufactured in the same manner as Example 2 except that the tantalum of the coating layer was replaced with bismuth.

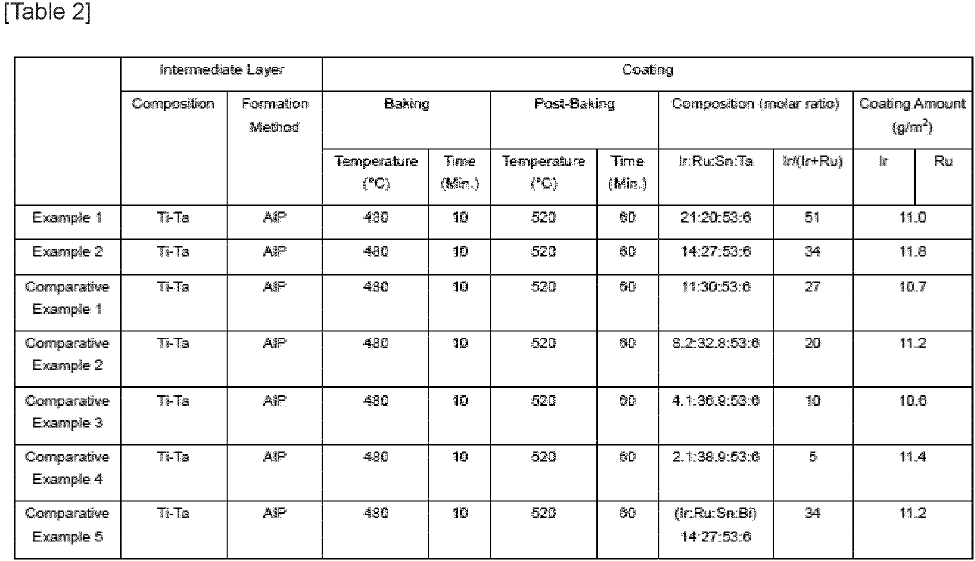

The thus manufactured electrodes were evaluated for their electrolytic life span under the following conditions.
Electrolytic Solution: Aqueous solution of 8.57 g/L ENSA, 20 g/L PSA, and 15 g/L Na₂SO₄
Electrolysis temperature: 50°C
Electrolysis area: 30 mm × 30mm
Counter electrode: Pt plate (30 mm × 30 mm)
Current density: 32 A/dm²

The point of time at which an increase of 2.0 V from the initial cell voltage was observed was defined as the electrolytic life span.

The electrolytic life spans of these electrodes are shown in Table 3.

**[Table 3]**

| | Life (time) in Durability Test |
|---|---|
| Example 1 | >1500 |
| Example 2 | >1500 |
| Comparative Example 1 | 1078 |
| Comparative Example 2 | 540 |
| Comparative Example 3 | 233 |
| Comparative Example 4 | 207 |
| Comparative Example 5 | 1168 |

From the electrolytic life span results shown in Table 3, it was found that the electrode life span decreased as the molar ratio of the iridium element to the total of the iridium element and the ruthenium element in the mixed metal oxide in the coating decreased. On the other hand, when the molar ratio of the iridium element to the total of the iridium element and the ruthenium element in the mixed metal oxide in the coating is 34% or more, it was shown that the life span is equivalent to that of an electrode having a high molar ratio of the iridium element.

In addition, it was also shown that an electrode using bismuth instead of tantalum has a shorter electrolytic life span than an electrode using tantalum.

### [Industrial Applicability]

The electrode of the present invention can be used as an electrode for generating oxygen in an industrial electrolysis process such as electrowinning and electroplating.

## Claims

1. An electrode comprising a coating that contains a mixed metal oxide on a valve metal substrate with an intermediate layer therebetween that contains an alloy that contains a titanium component and a tantalum component,
wherein the molar ratio of metal elements in the mixed metal oxide is 35 to 48% for the total of an iridium element and a ruthenium element, 45 to 60% of a tin element, and 3 to 9% of a tantalum element, and
the molar ratio of the iridium element to the total of the iridium element and the ruthenium element in the mixed metal oxide is 32 to 60% inclusive.

2. The electrode according to claim 1, wherein the molar ratio of the metal elements in the mixed metal oxide is 12 to 25% of the iridium element, 18 to 29% of the ruthenium element, 45 to 60% of the tin element, and 3 to 9% of the tantalum element, and
the molar ratio of the iridium element to the total of the iridium element and the ruthenium element in the mixed metal oxide is 33 to 52% inclusive.

3. The electrode according to claim 1 or 2, wherein the molar ratio of the metal elements in the mixed metal oxide is 13 to 16% of the iridium element, 24 to 28% of the ruthenium element, 50 to 56% of the tin element, and 4 to 8% of the tantalum element, and
the molar ratio of the iridium element to the total of the iridium element and the ruthenium element in the mixed metal oxide is 34 to 40% inclusive.

4. The electrode according to any one of claims 1 to 3, wherein the electrode is for oxygen generation in an electrolysis process.

5. A method for manufacturing an electrode, the method comprising
1) a step for forming, on a surface of a valve metal substrate, an intermediate layer precursor that contains an alloy that contains a titanium component and a tantalum component by means of an arc ion plating method,
2) a step for forming a coating precursor by applying, to the surface of the intermediate layer precursor, a solution containing iridium ions, ruthenium ions, tin ions, and tantalum ions and drying said solution, and
3) a step for heat processing in an atmosphere containing oxygen for 30 minutes to two hours at a temperature of 400 to 600°C.
